# FASCICULE DE BREVET EUROPEEN

(11) **EP 2 693 440 B1**
(45) Date de publication et mention de la délivrance du brevet: **04.07.2018**
(21) Numéro de dépôt: 13169505.8
(22) Date de dépôt: 28.05.2013
(51) Int. Cl.: G11C 27/02, G04F 10/10, H01L 29/66, H01L 49/02

(54) **Puce de circuit intégrée avec cellule mémoire non-volatile, transistor MOS et elément d'écoulement de charges électriques**
Integrierter Schaltungs-Chip mit nichtflüchtiger Speicherzelle, MOS Transistor und Strömungselement von elektrischen Ladungen
IC chip with non-volatile cell, transitor MOS and electrical load flow element

(30) Priorité: 30.07.2012 FR 1257354
(43) Date de publication de la demande: 05.02.2014
(73) Titulaire: ST Microelectronics (Rousset) SAS, 13790 Rousset (FR)
(72) Inventeur: Marinet, Fabrice, 13790 Châteauneuf le Rouge (FR); Fornara, Pascal, 83910 Pourrières (FR)
(74) Mandataire: Cabinet Beaumont

(56) Documents cités:
- WO-A1-03/083769
- WO-A2-2008/012464
- FR-A1- 2 981 190
- US-A1- 2002 084 479
- US-A1- 2006 003 522

## Description

### Domaine de l'invention

La présente invention concerne de façon générale les circuits électroniques, et en particulier la réalisation d'un circuit permettant de retenir des charges électriques de façon contrôlable pour une mesure temporelle. Elle vise plus particulièrement la réalisation d'un élément d'écoulement de charges électriques.

### Exposé de l'art antérieur

Dans de nombreuses applications, on souhaite disposer d'une information représentative d'un temps écoulé entre deux évènements, qu'il s'agisse d'une mesure précise ou approximative. Un exemple d'application concerne la gestion temporelle de droits d'accès, notamment à des médias.

L'obtention de cette information représentative du temps écoulé requiert classiquement une mesure temporelle par un circuit électronique alimenté, par exemple au moyen d'une batterie, afin de ne pas perdre l'évolution de l'information lorsque le circuit n'est pas utilisé.

Il serait souhaitable de disposer d'une mesure temporelle qui fonctionne même lorsque le circuit électronique de mesure n'est pas alimenté.

On a déjà proposé, par exemple dans la demande de brevet WO2008012459, un dispositif électronique dans lequel le temps écoulé entre deux évènements est déterminé en mesurant la charge d'un élément capacitif de stockage dont une électrode est connectée à une électrode d'un élément capacitif d'écoulement de charges présentant une fuite dans son espace diélectrique. L'élément de stockage est chargé lorsque le dispositif est alimenté, et sa charge résiduelle, après une interruption de l'alimentation, est mesurée lorsque le dispositif est de nouveau alimenté. Cette charge résiduelle est considérée comme représentative du temps écoulé entre les deux instants d'alimentation du dispositif.

L'élément d'écoulement de charges comprend une région de plus faible épaisseur dans son espace diélectrique, adaptée à laisser fuir des charges par effet tunnel. La vitesse de décharge de l'élément de stockage est liée aux dimensions de la région de fuite de l'élément d'écoulement. En particulier, la vitesse de décharge de l'élément de stockage croît lorsque l'épaisseur de la région de fuite diminue et/ou lorsque la surface (vu de dessus) de la région de fuite augmente.

Un inconvénient est que, en pratique, le dimensionnement de la région de fuite est fortement dépendant de la filière technologique de fabrication considérée. En effet, le circuit de rétention de charges est généralement intégré à une puce comportant d'autres composants, par exemple des mémoires, des blocs logiques, etc. Pour ne pas augmenter le coût de fabrication de la puce, on cherche à réaliser le circuit de rétention de charges sans étape de fabrication supplémentaire par rapport aux étapes de fabrication des autres composants. Dans certaines filières technologiques récentes, les couches diélectriques disponibles pour réaliser la région de fuite de l'élément d'écoulement sont trop minces pour permettre une décharge lente de l'élément de stockage, même en réduisant au maximum la surface de la région de fuite. Il en résulte que la mesure temporelle ne peut fonctionner, en l'absence d'alimentation, que pendant un temps très court inadapté à la plupart des applications.

Les demandes de brevet US2006/0003522 et US2002/0084479 décrivent des puces semiconductrices intégrant des éléments capacitifs, et les demandes de brevet WO03/083769, WO2008/012464 et FR291190 décrivent des circuits comportant un élément d'écoulement de charges pour une mesure temporelle. WO03/083769 décrit une puce de circuit intégré comportant un substrat semiconducteur incluant une région dopée (36,39,38), un support isolant, un transistor MOS comprenant au dessus de la région dopée une couche d'oxyde de silicium réalisée par un niveau diélectrique et un circuit électrique de rétention de charges pour une mesure temporelle comportant un élément capacitif de stockage de charges ((28b), (34) et (36)), et relié à cet élément capacitif, un élément d'écoulement de charges électriques (condensateur (20))comportant, sur le support isolant, un empilement d'une première électrode (26), d'une couche diélectrique (24) dont au moins une portion est adaptée à laisser circuler des charges par effet tunnel, et d'une seconde électrode (28a), ladite au moins portion est en oxyde de silicium réalisé par le niveau diélectrique et la première et la seconde électrode sont en silicium polycristallin de premier et second niveau respectivement.

### Résumé

Ainsi, un objet d'un mode de réalisation est de prévoir un élément d'écoulement de charges électriques palliant au moins en partie certains des inconvénients des éléments d'écoulement de charges connus.

Un autre objet d'un mode de réalisation est de prévoir un circuit de rétention de charges électriques contrôlable pour une mesure temporelle.

Ainsi, un mode de réalisation prévoit une puce de circuit intégré réalisée dans et sur un substrat semiconducteur, comportant : au moins une cellule mémoire non volatile comprenant, sur un support isolant, une électrode inférieure réalisée dans un premier niveau de silicium polycristallin, un empilement diélectrique d'oxyde-nitrure-oxyde réalisé dans un premier niveau diélectrique, et une électrode supérieure réalisée dans un second niveau de silicium polycristallin ; au moins un transistor MOS comprenant, au dessus d'une région dopée du substrat, une couche d'oxyde de silicium réalisée dans un second niveau diélectrique ; et un circuit électrique de rétention de charges pour une mesure temporelle, comportant un élément capacitif de stockage de charges et, relié à l'élément capacitif, un élément d'écoulement de charges électriques comportant, sur un support isolant, un empilement d'une première électrode réalisée dans le premier niveau de silicium polycristallin, d'une couche diélectrique dont au moins une portion est adaptée à laisser circuler des charges par effet tunnel, et d'une seconde électrode réalisée dans le second niveau de silicium polycristallin, dans laquelle ladite couche diélectrique comprend un empilement oxyde-nitrure-oxyde réalisé dans le premier niveau diélectrique, ladite au moins une portion est en oxyde de silicium du second niveau diélectrique, et au moins une des électrodes de l'élément d'écoulement est non dopée.

Selon un mode de réalisation, une des électrodes de l'élément d'écoulement est en silicium polycristallin fortement dopé.

Selon un mode de réalisation, les deux électrodes de l'élément d'écoulement sont en silicium polycristallin non dopé.

Selon un mode de réalisation, les électrodes inférieure et supérieure de ladite au moins une cellule mémoire non volatile sont en silicium polycristallin dopé.

Selon un mode de réalisation, l'élément d'écoulement présente une capacité entre ses deux électrodes comprise entre 1*10⁻¹⁵ et 10*10⁻¹⁵ farads.

Selon un mode de réalisation, l'élément capacitif de stockage a une capacité comprise entre 10⁻¹² et 100*10⁻¹² farads.

Selon un mode de réalisation, le circuit électrique comporte en outre un élément capacitif d'initialisation relié à un noeud flottant commun à l'élément de stockage et à l'élément d'écoulement.

Selon un mode de réalisation, l'élément capacitif d'initialisation a une capacité comprise entre 10*10⁻¹⁵ et 100*10⁻¹⁵ farads.

Un autre mode de réalisation prévoit l'utilisation de la puce susmentionnée pour une mesure temporelle.

Un autre mode de réalisation prévoit un élément d'écoulement de charges électriques comportant, sur un support isolant, un empilement d'une première électrode, d'une couche diélectrique dont au moins une portion est adaptée à laisser circuler des charges par effet tunnel, et d'une seconde électrode, dans lequel au moins une des électrodes est en silicium polycristallin non dopé.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1 est un schéma électrique d'un exemple d'un circuit adapté à retenir des charges électriques de façon contrôlable pour une mesure temporelle ;
la figure 2 est une vue en coupe représentant un exemple d'un élément d'écoulement de charges électriques ;
les figures 3A à 3H sont des vues en coupe représentant des étapes d'un procédé de fabrication d'un mode de réalisation d'un élément d'écoulement de charges électriques ;
la figure 4 est une vue en coupe représentant une variante de réalisation de l'élément d'écoulement de charges électriques de la figure 3H ; et
la figure 5 est une vue en coupe représentant une autre variante de réalisation de l'élément d'écoulement de charges électriques de la figure 3H.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle. Par ailleurs, seuls les éléments utiles à la compréhension de l'invention ont été représentés et seront décrits. En particulier, la destination des mesures temporelles générées par les circuits décrits n'a pas été détaillée, les modes de réalisation décrits étant compatibles avec les applications usuelles de telles mesures temporelles.

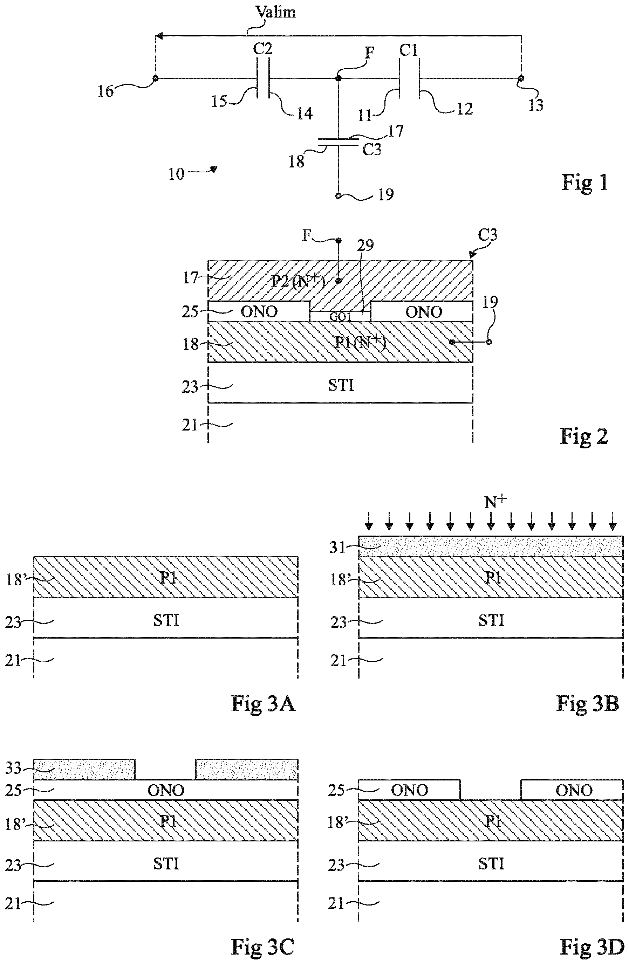

La figure 1 est un schéma électrique d'un exemple d'un circuit 10 adapté à retenir des charges électriques de façon contrôlable pour une mesure temporelle. Le circuit 10 comprend un premier élément capacitif C1 dont une première électrode 11 est connectée à un noeud flottant F et dont une seconde électrode 12 est connectée à une borne 13 d'application d'un potentiel, et un second élément capacitif C2 dont une première électrode 14 est connectée au noeud F et dont une seconde électrode 15 est connectée à une borne 16 d'application d'un potentiel. Le circuit 10 comporte en outre un troisième élément capacitif C3 dont une première électrode 17 est connectée au noeud F et dont une seconde électrode 18 est connectée à une borne 19 d'application d'un potentiel, et dont l'espace diélectrique est conçu, par sa permittivité et/ou par son épaisseur, pour présenter des fuites non négligeables dans le temps. L'élément capacitif C1 présente une capacité de rétention de charges supérieure à celle de l'élément C3, et l'élément capacitif C2 présente une capacité de rétention de charges supérieure à celle de l'élément C3, mais inférieure à celle de l'élément C1.

Un rôle de l'élément capacitif C1 (élément de stockage) est de stocker des charges électriques. Un rôle de l'élément capacitif C3 (élément d'écoulement) est de décharger l'élément de stockage C1, relativement lentement par rapport à une connexion directe de son électrode 11 à la masse. Un rôle de l'élément capacitif C2 est de permettre une injection (ou un retrait) rapide (par exemple au moins cent fois plus rapide que par l'élément capacitif C3) de charges dans l'élément capacitif C1.

Lors d'une étape d'initialisation d'une phase de rétention de charges, les bornes 13 et 19 sont à un potentiel de référence, par exemple la masse, et un potentiel d'alimentation haute (positif par rapport à la masse) Valim est appliqué sur la borne 16, ce qui entraîne la charge de l'élément capacitif C1. En variante, pour charger l'élément C1, la borne 19 peut être mise à la masse, et les bornes 16 et 13 à des potentiels respectivement positif et négatif par rapport à la masse.

Lorsque la tension d'alimentation n'est plus appliquée entre les bornes 16 et 13, par exemple lorsque le circuit n'est plus alimenté, l'élément de stockage C1 se décharge de façon contrôlée (relativement lentement) à travers l'élément d'écoulement C3. On notera qu'une phase de décharge contrôlée peut aussi être prévue lorsque le circuit est encore alimenté. Lors de la phase de décharge, les bornes 13, 16 et 19 peuvent être laissées flottantes, ou mises à un même potentiel de référence, par exemple la masse.

Lors d'une étape de lecture, après une phase de décharge, la charge résiduelle de l'élément de stockage C1 est mesurée (pour la mesure, le dispositif doit être alimenté). La charge résiduelle de l'élément C1 est considérée comme représentative du temps écoulé entre la fin de l'étape d'initialisation et l'étape de lecture.

Une étape de réinitialisation (remise à zéro) peut, le cas échéant, être prévue pour décharger entièrement l'élément de stockage C1 à travers l'élément capacitif C2. Pour cela les bornes 19 et 16 peuvent être mises à la masse, et la borne 13 à un potentiel d'alimentation haute (par exemple Valim). En variante, la borne 19 peut être mise à la masse, et les bornes 13 et 16 à des potentiels respectivement positif et négatif par rapport à la masse.

On peut aussi prévoir une phase de décharge contrôlée accélérée de l'élément de stockage C1 (à travers l'élément d'écoulement C3), par exemple à des fins de test du circuit de mesure temporelle. Pour cela, la borne 19 peut être mise à la masse ou à un potentiel négatif par rapport à la masse, et les bornes 13 et 16 peuvent être polarisées à un même potentiel positif par rapport à la masse, par exemple un potentiel compris entre le potentiel de masse et le potentiel Valim.

On notera qu'on peut aussi prévoir un mode de réalisation ne comprenant pas l'élément capacitif C2, dans lequel le noeud flottant F est chargé et déchargé par l'intermédiaire de l'élément capacitif C3. Dans ce cas, les temps de charge et de décharge sont symétriques.

Des exemples de réalisation et de fonctionnement d'un circuit de rétention de charges électriques pour une mesure temporelle, du type décrit en relation avec la figure 1, sont décrits de façon plus détaillée dans la demande de brevet WO200812459 déjà mentionnée ci-dessus. Ce document décrit notamment un exemple d'un circuit adapté à mesurer la charge résiduelle de l'élément de stockage C1 et à en déduire une information relative au temps écoulé entre la fin de l'étape d'initialisation d'une phase de rétention de charges, et l'étape de lecture.

On s'intéresse ici plus particulièrement à la réalisation de l'élément capacitif C3 d'écoulement contrôlé des charges électriques.

La figure 2 est une vue en coupe représentant un exemple d'un élément capacitif C3 d'écoulement de charges électriques pour une mesure temporelle. Dans cet exemple, l'élément C3 est réalisé dans une filière technologique de fabrication de puces semiconductrices comportant à la fois des mémoires non volatiles et des blocs logiques à base de transistors MOS (non visibles sur la figure). Les puces sont réalisées à partir d'un substrat semiconducteur 21, par exemple en silicium. Les mémoires non volatiles sont au moins partiellement réalisées sur une couche isolante 23, par exemple en oxyde de silicium. La couche 23 comprend par exemple des caissons isolants formés dans la partie supérieure du substrat selon une technique de réalisation de régions isolantes couramment appelée STI, de l'anglais "Shallow Trench Isolation" - isolation par tranchées peu profondes. Tout autre procédé de réalisation d'une couche isolante 23 d'épaisseur adaptée peut toutefois être utilisé. Chaque cellule mémoire comprend, superposés dans l'ordre à partir de la face supérieure de la couche 23, une électrode inférieure réalisée dans un premier niveau de silicium polycristallin P1 dopé, un empilement diélectrique oxyde-nitrure-oxyde (par exemple oxyde de silicium - nitrure de silicium - oxyde de silicium) correspondant à un premier niveau diélectrique ONO, et une électrode supérieure réalisée dans un second niveau de silicium polycristallin P2 dopé. Les transistors MOS comprennent, superposées dans l'ordre au dessus d'une région de substrat convenablement dopée, une couche d'oxyde de silicium (isolant de grille) réalisée dans un second niveau diélectrique GO1 d'épaisseur inférieure au niveau ONO, et une grille en silicium polycristallin dopé réalisée dans le niveau P2. Le dopage des niveaux P1 et P2 a pour effet d'augmenter la conductivité électrique du silicium polycristallin pour le rendre compatible avec une utilisation comme électrode ou grille dans des mémoires non volatiles et des transistors MOS. A titre d'exemple, le silicium polycristallin des niveaux P1 et P2 est d'abord déposé sous forme non dopée, puis une étape d'implantation d'éléments dopants, par exemple de type N (N⁺) est prévue immédiatement après le dépôt. La concentration en éléments dopants des niveaux P1 et P2 après implantation est par exemple comprise entre 5x10¹⁸ et 5x10²⁰ atomes/cm³.

On cherche à réaliser l'élément C3 d'écoulement de charges sans étapes supplémentaires par rapport aux étapes de fabrication des cellules mémoire et des transistors MOS, c'est-à-dire en utilisant uniquement les niveaux susmentionnés.

Pour cela, l'élément C3 d'écoulement de charges comprend un caisson isolant 23 en oxyde de silicium (STI), formé dans la partie supérieure du substrat 21, et une électrode inférieure 18 en silicium polycristallin dopé (N⁺), formée à la surface du caisson 23 dans le niveau P1. L'électrode 18 est revêtue d'une couche diélectrique 25, réalisée dans le niveau ONO. Une portion de la couche 25, définissant la région de fuite de l'élément d'écoulement C3, est éliminée par gravure, la gravure s'arrêtant sur le silicium polycristallin P1 de l'électrode 18, et une couche diélectrique 29, réalisée dans le niveau GO1, est formée sur l'électrode 18 à la place de la portion de couche 25 éliminée. L'élément d'écoulement de charges C3 comprend en outre une électrode supérieure 17 en silicium polycristallin dopé (N⁺), formée dans le niveau P2, revêtant les couches diélectriques 25 et 29.

La couche 29, définissant la région de fuite de l'élément C3, doit être adaptée, par son épaisseur et/ou sa permittivité diélectrique, à laisser s'écouler des charges électriques entre les électrodes 17 et 18, par effet tunnel. La vitesse d'écoulement des charges doit être non négligeable, mais suffisamment lente pour permettre une décharge lente de l'élément de stockage C1 (figure 1), et donc une mesure temporelle, en l'absence d'alimentation, pendant une durée significative, par exemple de plusieurs heures ou jours.

Dans certaines filières technologiques récentes, l'épaisseur de l'oxyde GO1 est de l'ordre 2 nm, ce qui n'est pas suffisant pour permettre une décharge lente de l'élément de stockage C1, même en réduisant au maximum la surface (vu de dessus) de la région de fuite 29. A titre d'exemple, pour une épaisseur d'oxyde GO1 de 2 nm, le temps de décharge de l'élément de stockage C1 est de l'ordre de la seconde, alors qu'il est de plusieurs heures pour une épaisseur d'oxyde GO1 de 3 nm.

Pour pallier cet inconvénient, on prévoit de réaliser un élément d'écoulement de charges électriques dans lequel au moins une des deux électrodes est en silicium polycristallin non dopé. L'absence de dopage a pour effet de rendre le silicium polycristallin plus résistif et de modifier la zone de charge d'espace, et par conséquent de réduire la vitesse d'écoulement des charges entre les deux électrodes.

Les figures 3A à 3H sont des vues en coupe représentant des étapes d'un procédé de fabrication d'un mode de réalisation d'un élément d'écoulement de charges électriques comprenant une électrode en silicium polycristallin non dopé.

La figure 3A illustre la réalisation d'un caisson 23 en oxyde de silicium (STI), formé dans la partie supérieure du substrat 21, et d'une électrode inférieure 18' formée dans le niveau de silicium polycristallin P1 et revêtant le caisson 23. On notera que la couche 23 n'est pas nécessairement un caisson de type STI mais peut être réalisée par tout autre procédé adapté de formation d'une couche isolante. Dans le cas où l'élément d'écoulement de charges est utilisé dans un circuit de mesure temporelle du type décrit en relation avec la figure 1, l'épaisseur de diélectrique (ou épaisseur équivalente) entre le substrat et l'électrode 18' est de préférence au moins égale à l'épaisseur du diélectrique de l'élément capacitif C2.

La figure 3B illustre une étape d'implantation d'éléments dopants dans le niveau de silicium polycristallin P1, visant à augmenter la conductivité du niveau P1 dans les régions de la puce dans lesquels ce niveau est utilisé pour réaliser des électrodes ou grilles de mémoires non volatiles ou de transistors. Selon un aspect, on prévoit, lors de cette étape, de masquer l'électrode inférieure 18' de l'élément d'écoulement de charges, par exemple au moyen d'un masque en résine 31, afin de ne pas doper l'électrode 18'. Le masque 31 est un masque déjà prévu dans les procédés existants pour protéger certaines régions de la puce lors de l'implantation du niveau de silicium polycristallin P1. Il n'est donc pas nécessaire de prévoir un masque dédié au masquage de l'électrode 18'. On prévoit simplement de ne pas ouvrir le masque existant en regard de l'électrode 18' lors de l'étape d'implantation du niveau P1.

La figure 3C illustre une étape de dépôt d'une couche diélectrique 25, réalisée dans le niveau ONO, à la surface de l'électrode 18' après retrait du masque 31. Un masque en résine 33 est formé à la surface de la couche diélectrique 25, délimitant une fenêtre coïncidant avec la région de fuite de l'élément d'écoulement.

La figure 3D illustre une étape au cours de laquelle la région non masquée de la couche diélectrique 25 est éliminée par gravure, la gravure s'arrêtant sur le silicium polycristallin P1 de l'électrode 18'. Le masque de résine 33 est ensuite retiré.

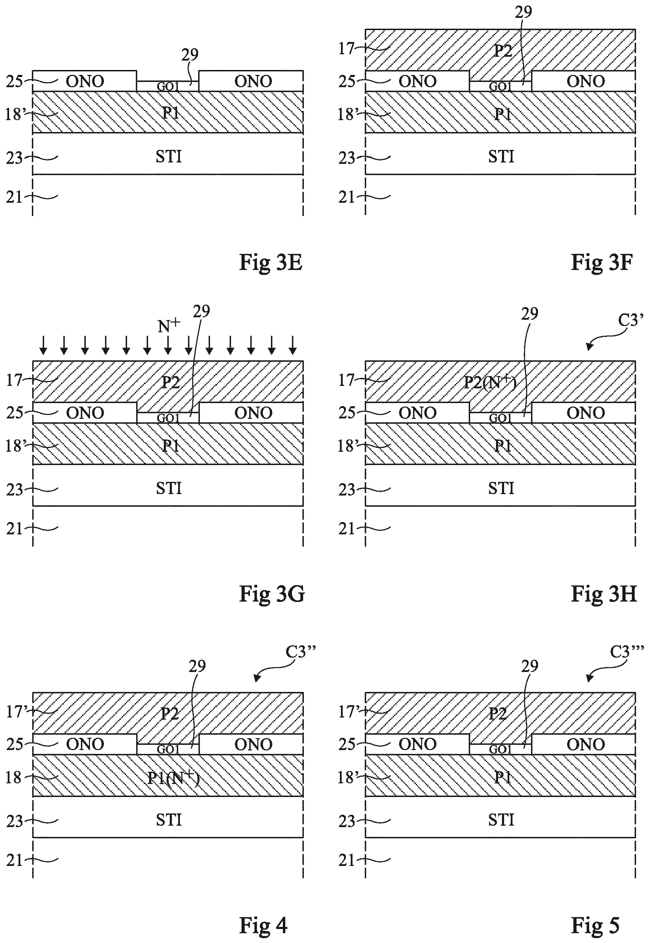

La figure 3E illustre une étape de formation d'une couche diélectrique 29, réalisée dans le niveau GO1, à la place de la portion de la couche 25 éliminée à l'étape précédente. A titre d'exemple, le niveau GO1 peut être réalisé par croissance d'oxyde, par exemple selon un procédé de traitement thermique rapide couramment désigné par le sigle RTP, de l'anglais "Rapid Thermal Processing".

La figure 3F illustre la formation d'une électrode supérieure 17 de l'élément d'écoulement de charges, dans le niveau de silicium polycristallin P2.

La figure 3G illustre une étape de dopage de l'électrode supérieure 17, par implantation d'éléments dopants, par exemple de type N (N⁺).

La figure 3H est une vue en coupe de l'élément d'écoulement de charges C3' obtenu à l'issue du procédé décrit en relation avec les figures 3A à 3G, c'est-à-dire un élément d'écoulement de charges comprenant, sur un support isolant 23, un empilement d'une électrode inférieure 18' en silicium polycristallin non dopé, d'une couche diélectrique 25, 29 comportant une portion 29 adaptée à laisser circuler des charges par effet tunnel, et d'une électrode supérieure 17 en silicium polycristallin dopé (N⁺).

A titre d'exemple, des essais menés par les inventeurs ont montré qu'en utilisant un oxyde mince G01 d'épaisseur de l'ordre 2 nm, la résistivité de l'élément d'écoulement de charges C3' de la figure 3H était de l'ordre de 5x10¹⁴ ohms par carré, contre 10¹² ohms par carré pour l'élément d'écoulement C3 de la figure 2.

Lorsque l'élément d'écoulement de charges C3' est utilisé dans un circuit de mesure temporelle du type décrit en relation avec la figure 1, ceci a pour effet de permettre une décharge lente de l'élément de stockage C1, sans modifier l'épaisseur de la région de fuite 29. A titre d'exemple, pour une épaisseur d'oxyde GO1 de 2 nm, le temps de décharge de l'élément de stockage C1 est de l'ordre de la seconde avec l'élément C3 de la figure 2, alors qu'il est de plusieurs jours avec l'élément C3' de la figure 3H (à surfaces de région de fuite identiques).

La figure 4 est une vue en coupe représentant une variante de réalisation de l'élément d'écoulement de charges électriques C3' de la figure 3H. Dans l'élément d'écoulement de charges C3" de la figure 4, l'électrode inférieure 18 est en silicium polycristallin dopé (N⁺), et c'est l'électrode supérieure 17' qui est en silicium polycristallin non dopé. Le masque (non représenté) utilisé pour masquer l'électrode 17' pendant l'implantation du niveau P2 est un masque déjà prévu dans les procédés existants pour protéger certaines régions de la puce lors de l'implantation du niveau de silicium polycristallin P2, ou pendant le dopage des régions de source-drain des transistors MOS. Il n'est donc pas nécessaire de prévoir un masque dédié au masquage de l'électrode 17'. On prévoit simplement de ne pas ouvrir le masque existant en regard de l'électrode 17' lors de l'étape d'implantation du niveau P2.

La figure 5 est une vue en coupe représentant une autre variante de réalisation de l'élément d'écoulement de charges électriques C3' de la figure 3H. Dans l'élément d'écoulement de charges C3"' de la figure 5, l'électrode inférieure 18' et l'électrode supérieure 17' sont toutes les deux en silicium polycristallin non dopé.

Un avantage des modes de réalisation décrits en relation avec les figures 3A à 3H, 4 et 5 est qu'ils ne nécessitent aucune étape supplémentaire par rapport aux étapes de fabrication d'une puce de circuit intégré comprenant à la fois des mémoires non volatiles et des blocs logiques à base de transistors MOS. Dans un exemple de réalisation d'un circuit de mesure temporelle du type décrit en relation avec la figure 1, l'épaisseur du diélectrique de l'élément de stockage C1 est comprise entre 15 et 20 nm, l'épaisseur du diélectrique de l'élément capacitif d'initialisation C2 est comprise entre 7 et 10 nm, l'épaisseur du niveau diélectrique GO1 est de l'ordre de 2 nm, et la surface, vu de dessus, des régions de fuite 29, est une surface carrée ou rectangulaire d'approximativement 0,3 à 0,4 µm par 0,4 à 0,5 µm, par exemple de 0,38 µm par 0,46 µm.

Pour le bon fonctionnement du circuit, le noeud F est de préférence flottant, c'est-à-dire séparé, par un espace diélectrique, de toute borne d'application de potentiel, et non directement connecté à une région non isolée du substrat semiconducteur de la puce (auquel cas les fuites dans le substrat pourraient être prépondérantes devant les fuites à travers l'élément d'écoulement).

A titre d'exemple de réalisation, la capacité de l'élément de stockage C1 est comprise entre 10⁻¹² et 100*10⁻¹² farads (1 à 100 picofarads), par exemple de l'ordre de 20*10⁻¹² farads, la capacité de l'élément d'initialisation C2 est comprise entre 100*10⁻¹⁵ et 10⁻¹² farads (100 à 1000 femtofarads), par exemple de l'ordre de 500*10⁻¹⁵ farads, et la capacité de chaque élément d'écoulement de charges C3', C3" ou C3'" est négligeable devant les capacités C1 et C2, par exemple comprise entre 1*10⁻¹⁵ et 10*10⁻¹⁵ farads (1 à 10 femtofarads), par exemple de l'ordre de 2*10⁻¹⁵ farads.

En tout état de cause, du fait des épaisseurs de diélectrique utilisées, les éléments capacitifs C1 et C2 présentent des fuites parasites (à travers leurs espaces diélectriques) négligeables par rapport à l'élément d'écoulement C3'. A titre d'exemple la capacité de l'élément C2 est réalisée en utilisant comme diélectrique un oxyde habituellement utilisé pour réaliser un point de mémoire non volatile apte à conserver une information pendant une durée d'au moins 20 ans, alors que la durée d'écoulement des charges à travers l'élément C3' peut être de l'ordre de quelques jours. A fortiori, l'épaisseur du diélectrique de l'élément C1 étant supérieure à l'épaisseur du diélectrique de l'élément C2, les fuites parasites à travers l'élément C1 sont tout à fait négligeables devant les fuites à travers l'élément d'écoulement.

Des modes de réalisation particuliers de la présente invention ont été décrits. Diverses variantes et modifications apparaîtront à l'homme de l'art. En particulier, l'homme du métier saura utiliser un élément d'écoulement de charges du type proposé dans tout circuit adapté à retenir des charges électriques pour une mesure temporelle, autre que celui décrit en relation avec la figure 1.

Par ailleurs, pour diminuer encore la vitesse d'écoulement des charges électriques, l'homme du métier saura réaliser un élément d'écoulement de charges comportant une pluralité d'éléments d'écoulement de charges du type décrit en relation avec les figures 3 à 5, reliés en série.

De plus, l'invention ne se restreint pas à l'utilisation d'un élément d'écoulement de charges du type décrit en relation avec les figures 3 à 5 pour une mesure temporelle. L'homme du métier saura utiliser un élément d'écoulement de charges du type décrit ci-dessus dans toute autre application nécessitant une résistance de forte valeur occupant une faible surface.

## Revendications

1. Puce de circuit intégré comportant :
un substrat semiconducteur comprenant une région dopée ;
un support isolant (23) disposé sur le substrat ;
au moins une cellule mémoire non volatile comprenant, sur le support isolant (23), une électrode inférieure réalisée par un premier niveau de silicium polycristallin (P1), un empilement diélectrique d'oxyde-nitrure-oxyde réalisé par un premier niveau diélectrique (ONO), et une électrode supérieure réalisée par un second niveau de silicium polycristallin (P2) ;
au moins un transistor MOS comprenant, au dessus de la région dopée, une couche d'oxyde de silicium réalisée par un second niveau diélectrique (G01) ; et
un circuit électrique de rétention de charges pour une mesure temporelle, comportant un élément capacitif (C1) de stockage de charges et, relié à l'élément capacitif (C1), un élément (C3' ; C3" ; C3"') d'écoulement de charges électriques comportant, sur le support isolant (23), un empilement d'une première électrode (18 ; 18') réalisée par le premier niveau de silicium polycristallin (P1), d'une couche diélectrique (ONO, GO1) dont au moins une portion (29) est adaptée à laisser circuler des charges par effet tunnel, et d'une seconde électrode (17 ; 17') réalisée par le second niveau de silicium polycristallin (P2),
dans laquelle ladite couche diélectrique (ONO, GO1) comprend un empilement oxyde-nitrure-oxyde réalisé par le premier niveau diélectrique (ONO), ladite au moins une portion (29) est en oxyde de silicium du second niveau diélectrique (GO1), et au moins une des électrodes (18' ; 17') de l'élément d'écoulement est non dopée.

2. Puce selon la revendication 1, dans laquelle une des électrodes (17 ; 18) de l'élément d'écoulement est en silicium polycristallin fortement dopé.

3. Puce selon la revendication 1, dans laquelle les deux électrodes (18', 17') de l'élément d'écoulement sont en silicium polycristallin non dopé.

4. Puce selon l'une quelconque des revendications 1 à 3, dans laquelle les électrodes inférieure et supérieure de ladite au moins une cellule mémoire non volatile sont en silicium polycristallin dopé.

5. Puce selon l'une quelconque des revendications 1 à 4, dans laquelle l'élément d'écoulement (C3' ; C3" ; C3"') présente une capacité entre ses deux électrodes comprise entre 1*10⁻¹⁵ et 10*10⁻¹⁵ farads.

6. Utilisation d'une puce selon l'une quelconque des revendications 1 à 5, pour une mesure temporelle.

7. Puce selon l'une quelconque des revendications 1 à 5, dans laquelle l'élément capacitif (C1) de stockage a une capacité comprise entre 10⁻¹² et 100*10⁻¹² farads.

8. Puce selon l'une quelconque des revendications 1 à 7, dans laquelle ledit circuit électrique comporte en outre un élément capacitif (C2) d'initialisation relié à un noeud (F) flottant commun à l'élément (C1) de stockage et à l'élément (C3' ; C3" ; C3"') d'écoulement.

9. Puce selon la revendication 8, dans laquelle l'élément capacitif (C2) d'initialisation a une capacité comprise entre 10*10⁻¹⁵ et 100*10⁻¹⁵ farads.

## Patentansprüche

1. Ein integrierter Schaltungschip, der Folgendes aufweist:
ein Halbleitersubstrat, das einen dotierten Bereich aufweist;
einen isolierenden Träger (23), der an dem Substrat angeordnet ist;
wenigstens eine nicht-flüchtige Speicherzelle, die auf dem isolierenden Träger (23) Folgendes aufweist: eine untere Elektrode, die in einer ersten Lage des Polysiliziums (P1) ausgeführt ist, ein Oxid-Nitrid-Oxid-Stapel, der in einem ersten dielektrischen Lage (ONO) ausgebildet ist, und eine obere Elektrode, die in einem zweiten Lage des Polysiliziums (P2) ausgebildet ist;
wenigstens einen MOS-Transistor, der an der Oberseite des dotierten Bereichs eine Silizium-Oxid-Schicht aufweist, die in einer zweiten dielektrischen Lage (GO1) ausgebildet ist; und
eine elektrische Ladungshalteschaltung für eine Zeitmessung, die ein kapazitives Ladungsspeicherelement (C1) und, gekoppelt an das kapazitive Ladungsspeicherelement (C1), ein elektrisches Ladungsflusselement (C3';
C3"; C3'") aufweist, das an dem isolierenden Träger (23) Folgendes aufweist: einen Stapel einer ersten Elektrode (18; 18'), die in der ersten Lage des Polysiliziums (P1) ausgebildet ist, einer dielektrischen Schicht (ONO, GO1), die wenigstens einen Teil (29) besitzt, der geeignet ist, Ladungen durch den Tunneleffekt fließen zu lassen, und einer zweiten Elektrode (17; 17'), die in der zweiten Lage des Polysiliziums (P2) ausgebildet ist,
wobei die dielektrische Schicht (ONO, GO1) einen Oxid-Nitrid-Oxid-Stapel aufweist, der in der ersten dielektrischen Lage (ONO) ausgebildet ist, wobei wenigstens ein Teil (29) aus Silizium-Oxid der zweiten dielektrischen Lage (GO1) hergestellt ist, und wenigstens eine der Elektroden (18'; 17') des Ladungsflusselements undotiert ist.

2. Integrierter Schaltungschip nach Anspruch 1, wobei eine der Elektroden (17; 18) des Ladungsflusselements aus stark dotiertem Polysilizium hergestellt ist.

3. Integrierter Schaltungschip nach Anspruch 1, wobei beide Elektroden (18', 17') des Ladungsflusselements aus undotiertem Polysilizium hergestellt sind.

4. Integrierter Schaltungschip nach einem der Ansprüche 1 bis 3, wobei die unteren und oberen Elektroden der wenigstens einen nicht-flüchtigen Speicherzelle aus dotiertem Polysilizium hergestellt sind.

5. Integrierter Schaltungschip nach einem der Ansprüche 1 bis 4, wobei das Ladungsflusselement (C3'; C3"; C3'") eine Kapazität zwischen seinen zwei Elektroden besitzt, die sich zwischen 1*10⁻¹⁵ und 10*10⁻¹⁵ Farad bewegt.

6. Eine Verwendung des integrierten Schaltungschips nach einem der Ansprüche 1 bis 5 für eine Zeitmessung.

7. Integrierter Schaltungschip nach einem der Ansprüche 1 bis 5, wobei das kapazitive Speicherelement (C1) eine Kapazität besitzt, die sich zwischen 10⁻¹² und 100*10⁻¹² Farad bewegt.

8. Integrierter Schaltungschip nach einem der Ansprüche 1 bis 7, wobei die Schaltung ferner ein kapazitives Initialisierungselement (C2) aufweist, das an einen potenzialfreien Knoten (F), der für das Speicherelement (C1) und für das Flusselement (C3'; C3"; C3'") üblich ist, gekoppelt ist.

9. Integrierter Schaltungschip nach Anspruch 8, wobei das kapazitive Initialisierungselement (C2) eine Kapazität besitzt, die sich zwischen 10*10⁻¹⁵ und 100*10⁻¹⁵ Farad bewegt.

## Claims

1. An integrated circuit chip comprising:
a semiconductor substrate comprising a doped region;
an insulating support (23) disposed on the substrate;
at least one non-volatile memory cell comprising, on the insulating support (23), a lower electrode realized in a first level of polysilicon (P1), an oxide-nitride-oxide dielectric stack realized in a first dielectric level (ONO), and an upper electrode realized in a second level of polysilicon (P2) ;
at least one MOS transistor comprising, on top of the doped region, a silicon oxide layer realized in a second dielectric level (G01); and
an electric charge retention circuit for a time measurement, comprising a capacitive charge storage element (C1), and, coupled to the capacitive charge storage element (C1), an electric charge flow element (C3'; C3''; C3"') comprising, on the insulating support (23), a stack of a first electrode (18; 18') realized in the first level of polysilicon (P1), of a dielectric layer (ONO, GO1) having at least one portion (29) capable of letting charges flow by tunnel effect , and of a second electrode (17 ; 17') realized in the second level of polysilicon (P2),
wherein said dielectric layer (ONO, GO1) comprises an oxide-nitride-oxide stack realized in the first dielectric level (ONO), said at least one portion (29) is made of silicon oxide of the second dielectric level (GO1), and at least one of the electrodes (18'; 17') of the charge flow element is undoped.

2. The integrated circuit chip of claim 1, wherein one of the electrodes (17; 18) of the charge flow element is made of heavily-doped polysilicon.

3. The integrated circuit chip of claim 1, wherein both electrodes (18', 17') of the charge flow element are made of undoped polysilicon.

4. The integrated circuit chip of any of claims 1 to 3, wherein the lower and upper electrodes of said at least one non-volatile memory cell are made of doped polysilicon.

5. The integrated circuit chip of any of claims 1 to 4, wherein the charge flow element (C3' ; C3" ; C3"') has a capacitance between its two electrodes ranging between 1*10⁻¹⁵ and 10*10⁻¹⁵ farads.

6. A use of the integrated circuit chip of any of claims 1 to 5, for a time measurement.

7. The integrated circuit chip of any of claims 1 to 5, wherein the capacitive storage element (C1) has a capacitance ranging between 10⁻¹² and 100*10⁻¹² farads.

8. The integrated circuit chip of any of claims 1 to 7, wherein the circuit further comprises a capacitive initialization element (C2) coupled to a floating node (F) common to the storage element (C1) and to the flow element (C3'; C3'' ; C3"').

9. The integrated circuit chip of claim 8, wherein the capacitive initialization element (C2) has a capacitance ranging between 10*10⁻¹⁵ and 100*10⁻¹⁵ farads.
